# EUROPEAN PATENT SPECIFICATION

(11) **EP 0 390 891 B1**
(45) Date of publication and mention of the grant of the patent: **06.03.1996**
(21) Application number: 89910505.0
(22) Date of filing: 15.09.1989
(51) Int. Cl.: H01L 21/48

(54) **METHOD OF FORMING HOLES IN CERAMIC IC PACKAGES**
VERFAHREN ZUM HERSTELLEN VON ÖFFNUNGEN IN KERAMISCHEN INTEGRIERTEN SCHALTUNGSPACKUNGEN
PROCEDE DE FORMATION DE TROUS DANS DES BOITIERS DE CIRCUITS INTEGRES EN CERAMIQUE

(30) Priority: 15.09.1988 US 244330
(43) Date of publication of application: 10.10.1990
(73) Proprietor: UNISYS CORPORATION, Blue Bell, PA 19424 (US); PACIFIC TRINETICS CORPORATION, San Marcos, CA 92069 (US)
(72) Inventor: CURTIS, Robert, David, Encinitas, CA 92024 (US); HORNER, James, William, San Diego, CA 92103 (US); NORELL, Ronald, Allen, Carlsbad, CA 92008 (US); ZABLOTNY, Gordon, Olivier, San Diego, CA 92129 (US)
(74) Representative: Eisenführ, Speiser & Partner
(86) International application number: US8904003
(87) International publication number: WO9003045

(56) References cited:
- EP-A- 0 144 046
- EP-A- 0 171 662
- EP-A- 0 238 282
- US-A- 3 956 052
- US-A- 4 346 516
- Research Disclosure, No. 289, May 1988, New York, US, "Debris Reduction for laser drilling of green ceramic sheets"
- 32nd Electronic Components Conference, 10-12 May 1982, San Diego, CA, US T. OHSAKI et al.: "New thick film multilayer interconnection technology using a Nd-YAG Laser", pages 543-550
- Journal Vacuum Science and Technology, B3(5), Sept./Oct. 1985, pages 1441-1444

## Description

### BACKGROUND

This invention relates to multilayer ceramic integrated circuit packages; and more particularly, it relates to a method for forming holes in the unfired layers of such packages during their fabrication.

Integrated circuits are conventionally fabricated on thin flat semiconductor chips which are about five to fifteen millimeters across and about one millimeter thick. These chips are quite fragile; and consequently, they are usually encapsulated in a package to protect them from damage. Such an integrated circuit package also contains conductors which contact microscopic bonding pads on the chip and thereby provide a means for sending electrical signals to and receiving electrical signals from the chip.

In Research Disclosure, no. 289, May 1988 (New York, US), "Debris reduction for laser drilling of green ceramic sheets " (page 353, abstract 289120) it is said that when a laser is used to drill a via through green ceramic, a "serious problem" is that ceramic debris partially blocks the via; and what this prior art really discloses is a process by which the amount of debris that is left in the via is "reduced". Thus, this prior art does not solve the debris depositing problem.

According to this prior art, the ideal solution to the problem is that "the laser energy should be deposited into just the binder". However, it is not practically possible for a laser to deposit its energy into the binder but not the ceramic particles of a green ceramic sheet.

As an alternative to the above "ideal solution" to the debris depositing problem, the above prior art document proposes that the size of the ceramic particles in the green ceramic sheet must be made "small" in order to increase the rate of heat transfer from the particles to the binder. According to this prior art document, "if the heat transfer from the particles to the binder is inefficient, the binder will vaporize slowly, permitting the particles to get sufficiently hot to melt which results in debris". However, as the ceramic particles get smaller in size, it takes less energy to melt them. Thus, the known method is faced with a dilemma in that making the ceramic particles smaller transfers more heat to the binder; but at the same time, the particles themselves melt with less energy. Consequently, the known method was not capable of eliminating debris in the via holes.

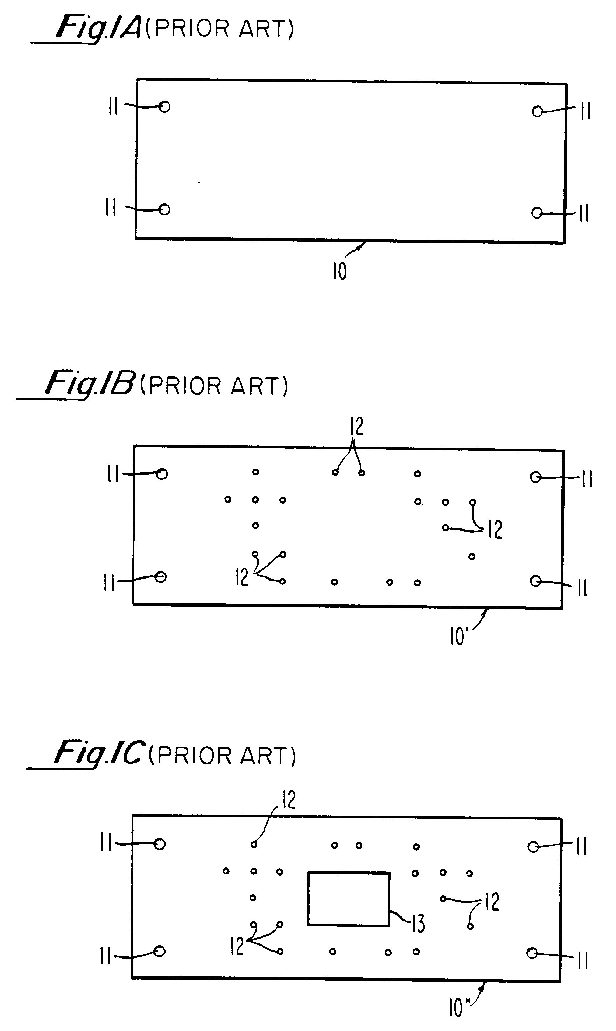

A further conventional process for making multilayer ceramic integrated circuit packages is illustrated in FIGs. 1A, 1B, and 1C. Initially, a sheet of unfired ceramic is cut with a punch to form a part 10 of FIG. 1A. Part 10 is rectangular in shape, and it has several tooling holes 11. Thereafter, the part 10 is aligned under a second punch by means of the tooling holes 11; and it punches many small via holes 12 in the part. This results in part 10' as is shown in FIG. 1B. Subsequently, the part 10' is positioned under a third punch by means of the tooling holes 11, and it punches a central aperture 13 in the part. This results in part 10'' as is shown in FIG. 1C.

Part 10'' is just one layer of a complete integrated circuit package; and typically, the package will have from four to sixteen layers. All of the steps of FIGs. 1A-1C are repeated for each of the upper layers of the package, and the steps of FIGs. 1A-1B are repeated for the lower layers.

After the parts 10' and 10'' are formed, the via holes 12 are filled with a conductive ink. Next, patterned conductive traces are screened on them. Then, the parts are arranged in a stack in which the tooling holes 11 are utilized to align the various layers. This stack is then compressed and "fired" at a temperature of about 80% of the melting temperature of the powder in the layers, which causes the powder to sinter and agglomerate. Then, to complete the package, an integrated circuit chip is placed in the aperture 13; wire bonds are made between the chip and the conductive traces around the perimeter of aperture 13; and a lid is sealed over the aperture.

This process has been used in the prior art to make millions of integrated circuit packages. However, the process does have several limitations which are very serious for certain types of packages. In particular, as the diameter of the via holes 12 becomes smaller and smaller, the punches which form those holes become weak and break. Thus, as a practical matter for a high volume production operation, the punched via holes 12 have a minimum diameter of about 0.254 mm (10 mils).

Also, as the total number of via holes 12 on a part 10' or 10'' increases, the corresponding punch becomes more difficult to make and thus more expensive. This added expense is multiplied by the number of layers in the package since each layer has a different via hole pattern and thus requires a different punch. Further, unfired ceramic is a very abrasive material, and thus the punches wear out. So in a production environment, the total number of via holes in any one punched part is limited to about 300.

Further, when the tooling holes 11 are used to position the parts 10' and 10'' during the punching operations of FIGs. 1B and 1C, those holes 11 become slightly stretched. These stretched holes will cause the parts to become misaligned when they are subsequently arranged in a stack. In turn, the misalignment can cause a short circuit or an open circuit between a filled via hole of one layer and a conductive trace on an adjacent layer. Such defects are not repairable, and so just one defect will cause the package to be scrapped.

Accordingly, a primary object of the invention is to provide an improved method of fabricating multilayer integrated circuit packages in which all of the above problems are overcome.

This object is achieved by a method according to claim 1.

Further advantageous embodiments are defined in the sub-claims.

### BRIEF DESCRIPTION OF THE DRAWINGS

Various features and advantages of the invention are described herein in conjunction with the accompanying drawings wherein:
FIGs. 1A, 1B, and 1C illustrate a process for punching via holes, tooling holes, and a central aperture in an unfired layer of ceramic in accordance with a prior art method of fabricating integrated circuit packages;
FIG. 2 illustrates a laser machine for drilling via holes, and cutting tooling holes and a central aperture, in an unfired layer of a ceramic integrated circuit package in accordance with the invention;
FIG. 3 is a microphotograph of a via hole in an unfired ceramic layer which is drilled in accordance with the invention by the machine of FIG. 2;
FIG. 4 is a microphotograph of the edge of a cut in an unfired ceramic layer that is made by the machine of FIG. 2 in accordance with the invention;
FIG. 5 is a microphotograph of-a via hole in an unfired ceramic layer which is drilled by a laser incorrectly; and
FIG. 6 is a microphotograph of a cut in an unfired ceramic layer which also is made by a laser incorrectly.

### DETAILED DESCRIPTION OF THE PREFERRED EMBODIMENTS OF THE INVENTION

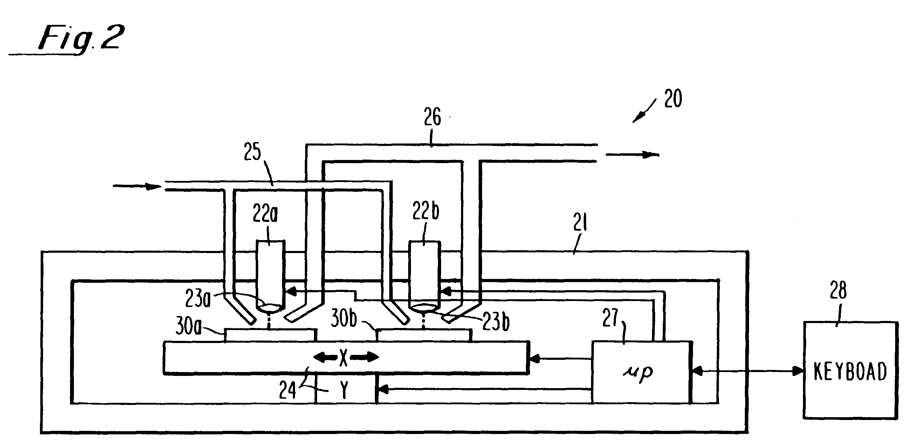

Referring now to FIG. 2, a machine for drilling and cutting holes in the uncured ceramic layer of an integrated circuit package, in accordance with the invention, will be described in detail. This machine 20 includes a housing 21, a pair of lasers 22a and 22b, a pair of lenses 23a and 23b, an X-Y positioning table 24, an input air jet conduit 25, an output vacuum conduit 26, a microprocessor 27, and a keyboard 28. All of these components are mounted and interconnected as illustrated in FIG. 2.

In operation, separate thin flat pieces of unfired ceramic 30a and 30b are placed on table 24 beneath the lenses 23a and 23b respectively. Thereafter, a gas is forced under pressure through conduit 25 while a vacuum is simultaneously applied to conduit 26. As that is occurring, microprocessor 27 sends a sequence of control signals to the X-Y positioning table 24 and the lasers 22a and 22b. Those control signals are initiated by a "start" command that is entered by an operator via the keyboard 28.

In response to the control signals to the X-Y positioning table 24, the table sequentially moves the ceramic pieces 30a and 30b to all of the locations under the lenses 23a and 23b where the via holes are to be drilled. And at each of those locations, the control signals to the lasers 22a and 22b cause them to emit respective laser beams at a certain low power density onto the underlying ceramic pieces.

Each of the unfired ceramic pieces 30a and 30b consists essentially of a homogeneous composition of an inorganic nonmetallic powder having a high melting temperature and a binder having a substantially lower vaporizing temperature. Preferably, the difference between the vaporizing temperature of the binder and the melting temperature of the powder is at least 200°C. This difference enables the power density of the lasers 22a and 22b to be controlled to a low level which will vaporize the binder at the location in the unfired ceramic where the laser is directed while the powder remains unsintered.

When the binder is vaporized under the laser beam, the powder at that location becomes unbound. As that occurs, the unbound powder is immediately removed from the laser beams by an air jet and a vacuum which the conduits 25 and 26 respectively produce. This simultaneous action of locally vaporizing the binder under the low power laser beams and immediately removing the unbound powder in its solid state produces high quality via holes which are defect free.

The power density of each laser beam is controlled to be between 5kW/cm and 75kW/cm. Higher power densities will melt and/or vaporize the powder in the unfired ceramic composition, and that produces defects in the via holes. Preferably, the time duration of the laser beam for each hole through the unfired ceramic layer of up to 0.762 mm (30 mils) thickness is between 2 and 8 milliseconds.

One specific example of a suitable powder in the unfired ceramic composition is 90% to 96% (by weight) aluminum oxide with the remainder being a mixture of silicon dioxide, calcium oxide, and magnesium oxide. Coloring agents such as chrome oxide, iron oxide, and molybdenum oxide can also be added as desired. Such a powder has a melting temperature of 1500°C-2000°C.

Another example of a suitable powder is 45% to 55% aluminum oxide with the remainder being boron oxide and silicon dioxide. This powder can also contain any one of a number of glass-modifying materials such as zinc oxide or aluminum oxide-magnesium oxide-silicon dioxide compositions known as forsterite or cordierite. Such a powder has a melting temperature in the range of 900°C-1000°C.

Still another suitable powder is >99% aluminum oxide, aluminum nitride, silicon carbide, and mullite. These powders have melting temperatures of about 1500°C to 2200°C.

Some specific examples of suitable binders are the acrylic resin binders #5200™⃝ from Du Pont and B7™⃝ from Rohm & Haas. They vaporize at 300°C-500°C.

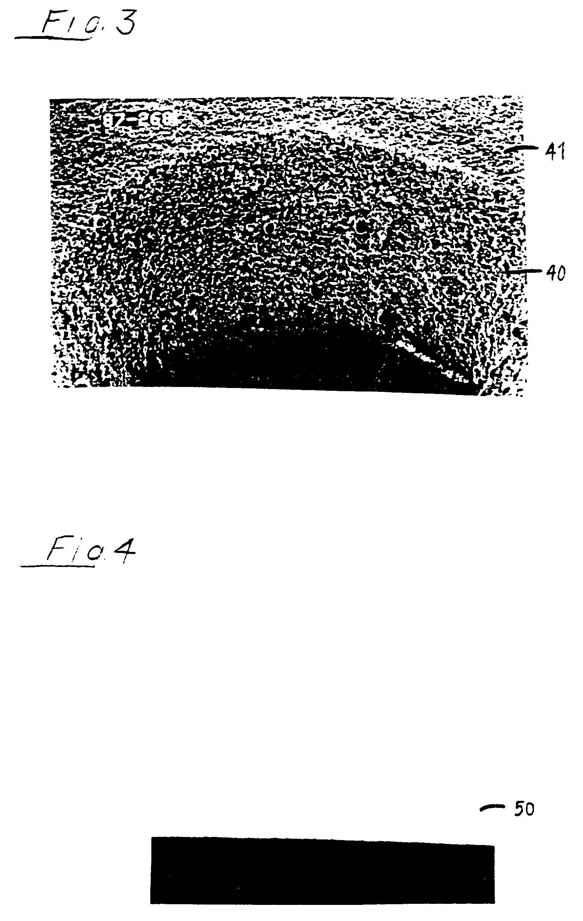

Figure 3 is a microphotograph of a via hole which was drilled in a piece of unfired ceramic by the above-described process. In this particular unfired ceramic composition, the powder had a melting temperature of about 900°C and the binder had a vaporizing temperature of about 400°C. Also, this particular hole is 0.2032 mm (8 mils) in diameter and 0.1016 mm (4 mils) deep. It was formed by a 0.2032 mm (8-mil) diameter CO₂ laser beam whose power was controlled to 3.8-4.6 watts, or about 13kW/cm.

One particular structural feature of the FIG. 3 via hole is that its ceramic sidewalls have not been melted by the laser beam. This is evident from inspection of FIG. 3 which shows that the texture of the via hole sidewalls 40 has uniformly small grains.

Another feature of the FIG. 3 via hole is that it has a clean and sharply defined perimeter. This is evident from inspection of the top surface 41 in FIG. 3 which shows that no contamination or vapor residue is deposited around the hole perimeter.

Considering now FIG. 4 it shows the top surface of a cut that was made through a 0.508 mm (20 mil) thick layer of unfired ceramic by directing an 0.2032 mm (8 mil) diameter CO₂ laser beam at the layer while it was moved by the X-Y positioning table 24. In this particular unfired ceramic composition, the powder had a melting temperature of about 1500°C, and the binder had a vaporizing temperature of about 500°C. During this cutting operation, the laser beam had a power density of about 67kW/cm; the unfired ceramic layer was moved at about 2.54 cm (one inch) per second; and the air jet and vacuum from conduits 25 and 26 respectively were applied.

Inspection of FIG. 4 shows that the cut is defect free. In particular, there is no vapor residue or contamination built up along the edge 50 of the cut. Also, the texture of the cut has uniformly small grains, just like the via hole of FIG. 3.

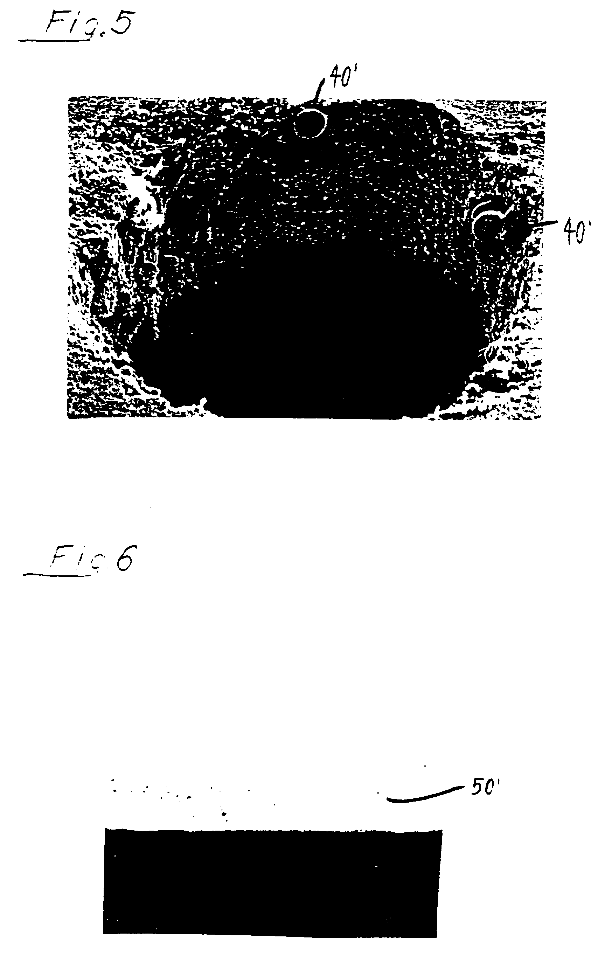

By comparison, FIG. 5 is a microphotograph of a via hole which was formed by an unsuitable modification to the above-described laser drilling process. That FIG. 5 via hole is of the same diameter and same depth as the FIG. 3 via hole, and it is made in the same type of unfired ceramic material. Also, it was made with a CO₂ laser while an air jet and a vacuum were applied to the location where the hole was being formed. However, the power density of the laser beam which farmed the FIG. 5 hole was 130kW/cm. That increased power density caused some of the ceramic powders on the sidewall of the via hole to melt and/or vaporize, and then resolidify; and that produced the large beads or spheres of ceramic 40' on the sidewall.

Such firing of the via hole sidewalls renders the process unsuitable for use in making integrated circuit packages. That is because firing the ceramic causes it to shrink by about ten to twenty percent. But that shrinkage is not supposed to occur until the last steps of the manufacturing process in which several unfired ceramic layers whose via holes are filled with conductive ink are arranged in a stack and fired together. Firing ceramic after its holes are filled with ink allows both the ceramic and the conductive ink to shrink together. If the ceramic around the via hole is prefired and preshrunk, then the conductive ink will fall out of the via hole when it is subsequently fired and shrunk.

Also for comparison purposes, FIG. 6 shows the top surface of a cut which was formed by an 8 mil diameter CO2 laser on the same material as that used in FIG. 4. This laser had a power density of only 25kW/cm, but the air jet and vacuum were not applied during the cutting operation. Such removal of the air jet and vacuum causes a vapor residue 50' to be deposited around the perimeter of the cut as well as on the lenses 23a and 23b of the lasers. This residue around the cut is a contaminant which can cause delamination between one layer and another of an integrated circuit package, and between one layer and a conductive trace such as a bonding pad. Also, such a residue on the lenses of the lasers will alter the beam power density.

Utilizing the above-described process of FIG. 3, via holes can be made with diameters that are much smaller than that which is practical with a punch. This is achieved by using a lens 23a or 23b in the FIG. 2 machine which focuses the laser beam to the desired beam diameter. Further, adjustable via hole diameters can be achieved by mounting the lenses 23a and 23b on a micrometer which moves perpendicular to the X-Y positioning table 24.

Another feature of the process of FIG. 3 is that the total number of via holes that are formed in any one layer can easily exceed that which is practical with a punch. Thousands of holes in any pattern are formed simply by programming the microprocessor 26. Further, by storing that program in a read/write memory, the number of holes and their pattern can quickly and inexpensively be modified by simply modifying the program.

Still another advantage of the process of FIGs. 3 and 4 is that all of the via holes plus the tooling holes plus the central aperture are formed with a very close location tolerance. That occurs because the laser beam forms all of those holes in one operation. This eliminates the stretching and deformation of the tooling holes which occurs when the separate punching operations of FIGs. 1A, 1B, and 1C are used.

A preferred process for forming multilayer ceramic integrated circuit packages in accordance with the invention, as well as the machine for carrying out that process, has now been described in detail.

In particular, various types of focusing lenses can be used in the machine of FIG. 2. One specific example of a suitable focusing lens is a pair of bi-convex lenses which are spaced along an optic axis by a distance that is greater than the sum of the focal length of each lens. Such lenses, and others, are available from Melles Griot Corporation of Irvine, California.

Further, many different X-Y positioning tables can be used as table 24 in the machine of FIG. 2. One specific table that is suitable is a 12" X-Y slide table model 3342 ™⃝ from Anorad Corporation of Hauppauge, New York.

Similarly, many different microprocessors 27 can be used in the machine of FIG. 2 to generate the control signals to the X-Y positioning table and the lasers 22a-22b. Some specific examples are the Intel 80386 ™⃝ , the Motorola 68030™⃝ , the Zilog Z80000™⃝ , the National Semiconductor 21021™⃝ , and their associated program memories.

Further, the number of lasers that are included in the machine of FIG. 2 can be increased or decreased. An inexpensive version of the FIG. 2 machine can have just one laser, whereas a high volume production machine can have a dozen lasers.

Also, the unfired ceramic layer which is operated on by the machine of FIG. 2 can be used as a component in various products besides an integrated circuit package. For example, the unfired ceramic layer can be part of a ceramic capacitor.

## Claims

1. A method of laser cutting via holes in a thin workpiece
comprising the steps of:
forming a layer of said workpiece with an unfired homogeneous composition that consists essentially of an inorganic nonmetallic powder which starts melting at a high temperature and a binder having a lower vaporizing temperature relative to said high melting temperature; directing a laser beam, in a sequence, at certain locations on said layer where via holes are to be formed;
heating said mixture at said location with said directed laser beam to a certain temperature which is above said vaporizing temperature of said binder and below said melting temperature of said powder; removing from said directed laser beam during the above steps, both the vaporized binder and the powder of said mixture as the powder becomes unbound, by impinging a gas jet at said location where said laser beam is directed and simultaneously vacuuming said location whereby an opening at said location is formed; and
keeping the power density of said directed laser beam at a level which will vaporize said binder, but not melt said powder, with said level being between 5 and 75 kW per cm throughout said heating step.

2. A method according to claim 1 wherein said vaporizing temperature of said binder and said melting temperature of said powder are selected such that they differ by at least 200°C.

3. A method according to claim 2 and further including the step of cutting additional holes in said workpiece, which are substantially larger than said via holes, by shining said laser beam at said controlled power density around the perimeter of said additional holes while performing said removing step.

4. A method according to claim 3 wherein each vaporized via hole in said workpiece is formed with a width of less than 0.254 mm (10 mils).

5. A method according to anyone of claims 1 to 4, wherein said laser beam is directed at said location on said unfired layer of up to 0,762 mm (30 mils) thickness for between 2 and 8 milliseconds.

6. A method according to claim 3, wherein the number of vaporized via holes formed in said workpiece exceeds 300.

7. A method according to claim 3, wherein said layer is from 0,0254 mm (1 mil) to 0,762 mm (30 mils) thick.

8. A method according to claim 3 wherein said directing, controlling, and removing steps are performed by multiple lasers which operate in parallel on respective workpieces.

## Patentansprüche

1. Verfahren zum Laserschneiden von Durchgangslöchern in einem dünnen Werkstück, welches die Schritte enthält:
Bilden einer Schicht dieses Werkstückes mit einer ungebrannten, homogenen Zusammensetzung, die im wesentlichen aus einem anorganischen, nicht metallischen Pulver, welches bei einer hohen Temperatur zu schmelzen beginnt, und einem Bindemittel besteht, welches eine gegenüber der hohen Schmelztemperatur geringere Verdampfungstemperatur aufweist;
aufeinanderfolgendes Richten eines Laserstrahls auf bestimmte Stellen auf dieser Schicht, an denen Durchgangslöcher zu bilden sind;
Erhitzen der Mischung an dieser Stelle mit dem darauf gerichteten Laserstrahl auf eine bestimmte Temperatur, welche über der Verdampfungstemperatur des Bindemittels und unter der Schmelztemperatur des Pulvers liegt;
Entfernen sowohl des verdampften Bindemittels als auch des Pulvers der Mischung, wenn es die Bindung verliert, aus dem ausgerichteten Laserstrahl während der vorstehenden Schritte durch Beaufschlagen dieser Stelle, auf die der Laserstrahl gerichtet ist, mit einem Gasstrom bei gleichzeitigem Untervakuumsetzen dieser Stelle, wodurch eine Öffnung an dieser Stelle gebildet wird; und
Halten der Energiedichte des ausgerichteten Laserstrahls auf ein Niveau, welches das Bindemittel verdampfen, nicht jedoch das Pulver schmelzen wird, wobei dieses Niveau zwischen 5 und 75 kW pro cm durchgehend während des Erhitzungsschrittes liegt.

2. Verfahren nach Anspruch 1,
bei dem die Verdampfungstemperatur des Bindemittels und die Schmelztemperatur des Pulvers so gewählt sind, daß sie sich um zumindest 200°C unterscheiden.

3. Verfahren nach Anspruch 2,
bei dem weiterhin der Schritt des Schneidens von zusätzlichen Löchern in dem Werkstück vorgesehen ist, die wesentlich größer als die Durchgangslöcher sind, durch Richten des Laserstrahls mit der kontrollierten Energiedichte entlang des Umfangs der zusätzlichen Löcher, während der Entfernungsschritt durchgeführt wird.

4. Verfahren nach Anspruch 3,
bei dem jedes verdampfte Durchgangsloch in dem Werkstück mit einer Weite von weniger als 0,254 mm (10 mils) gebildet wird.

5. Verfahren nach einem der Ansprüche 1 bis 4,
bei dem der Laserstrahl an die Stelle auf der ungebrannten Schicht von bis zu 0,762 mm (30 mils) Dicke für zwischen 2 und 8 Millisekunden gerichtet wird.

6. Verfahren nach Anspruch 3,
bei dem die Anzahl der verdampften Durchgangslöcher, die in dem Werkstück gebildet werden, 300 überschreitet.

7. Verfahren nach Anspruch 3,
bei dem die Schicht von 0,0254 mm (1 mil) bis 0,762 mm (30 mils) dick ist.

8. Verfahren nach Anspruch 3,
bei dem die Richt-, Steuer- und Entfernungsschritte durch Mehrfachlaser ausgeführt werden, die parallel an jeweiligen Werkstücken arbeiten.

## Revendications

1. Procédé de découpe au laser de trous traversants dans une pièce d'oeuvre mince comprenant les étapes de :
formation d'une couche de ladite pièce d'oeuvre ayant une composition homogène non cuite qui est constituée essentiellement de poudre non métallique inorganique qui commence à fondre à une température élevée et d'un liant ayant une température de vaporisation basse par rapport à ladite température de fusion élevée;
d'orientation d'un rayon laser, en une séquence, vers certaines localisations sur ladite couche où les trous traversants doivent être formés;
chauffage dudit mélange au niveau de ladite localisation au moyen dudit rayon laser orienté jusqu'à une certaine température qui est supérieure à ladite température de vaporisation dudit liant et inférieure à ladite température de fusion de ladite poudre;
retrait dudit rayon laser orienté durant les étapes ci-dessus, le liant vaporisé et la poudre dudit mélange en tant que poudre deviennent tous les deux libres, en injectant un jet de gaz au niveau de ladite localisation vers laquelle ledit rayon laser est orienté et en créant simultanément une dépression au niveau de ladite localisation grâce à quoi une ouverture au niveau de ladite localisation est formée; et
maintien de la densité de puissance dudit rayon laser orienté à un niveau qui va vaporiser ledit liant, mais ne pas faire fondre ladite poudre, ledit niveau se trouvant entre 5 et 75kW/cm pendant la totalité de l'étape de chauffage.

2. Procédé selon la revendication 1, dans lequel ladite température de vaporisation dudit liant et ladite température de fusion de ladite poudre sont choisies de telle façon qu'elles ont une différence d'au moins 200°C.

3. Procédé selon la revendication 2 et comprenant en outre l'étape de découpe de trous supplémentaires dans ladite pièce d'oeuvre, qui sont sensiblement plus grands que lesdits trous traversants, en faisant rayonner ledit rayon laser au niveau de ladite densité de puissance commandée autour du périmètre desdits trous supplémentaires tout en accomplissant ladite étape de retrait.

4. Procédé selon la revendication 3, dans lequel chaque trou traversant vaporisé dans ladite pièce d'oeuvre est formé avec une largeur inférieure à 0,254mm (10 mils).

5. Procédé selon l'une quelconque des revendications 1 à 4, dans lequel ledit rayon laser est orienté au niveau de ladite localisation vers ladite couche non cuite ayant une épaisseur allant jusqu'à 0,762mm (30 mils) pendant entre 2 et 8 millisecondes.

6. Procédé selon la revendication 3, dans lequel le nombre de trous traversants vaporisés formés dans ladite pièce d'oeuvre dépasse 300.

7. Procédé selon la revendication 3, dans lequel ladite couche a une épaisseur qui va de 0,0254mm (1 mil) à 0,762mm (30 mils).

8. Procédé selon la revendication 3, dans lequel lesdites étapes d'orientation, de commande et de retrait sont accomplies par des lasers multiples qui travaillent en parallèle sur leurs pièces d'oeuvre correspondantes.
